# EUROPÄISCHE PATENTSCHRIFT

(11) **EP 0 637 792 B1**
(45) Veröffentlichungstag und Bekanntmachung des Hinweises auf die Patenterteilung: **21.10.1998**
(21) Anmeldenummer: 94111414.2
(22) Anmeldetag: 21.07.1994
(51) Int. Cl.: G06F 1/12, H03K 5/13, H03K 5/14

(54) **Phasenregelanordnung**
Phase control apparatus
Dispositif de réglage de phase

(30) Priorität: 03.08.1993 DE 4326062
(43) Veröffentlichungstag der Anmeldung: 08.02.1995
(73) Patentinhaber: SIEMENS AKTIENGESELLSCHAFT, 80333 München (DE)
(72) Erfinder: Werker, Dipl.-Ing. Heinz, D-82024 Taufkirchen (DE)

(56) Entgegenhaltungen:
- EP-A- 0 059 802
- EP-A- 0 116 669
- EP-A- 0 236 525
- EP-A- 0 440 357
- FR-A- 2 635 239
- US-A- 5 012 142
- US-A- 5 051 630
- IEEE JOURNAL OF SOLID-STATE CIRCUITS, Bd.23, Nr.5, Oktober 1988, NEW YORK US Seiten 1218 - 1223 JOHNSON ET AL. 'A variable delay line PLL for CPU-coprocessor synchronization'

## Beschreibung

Die Erfindung betrifft eine Phasenregelanordnung mit einem Phasendetektor, an den ein Referenzsignal sowie ein über eine steuerbare Verzögerungseinrichtung geführtes Eingangssignal angelegt sind, mit einem dem Phasendetektor nachgeschalteten Regler, der die quer zwischen dem Signalpfad und jeweils einem Kondensator geschaltete Laststrecke mindestens eines Feldeffekttransistors in der Verzögerungseinrichtung zur Regelung in einem geringen Detektionsbereich steuert und mit mindestens einem Inverter im Signalpfad der Verzögerungseinrichtung.

EP-A-0 059 802 offenbart eine Regelanordnung mit einer steuerbaren Verzögerungseinrichtung und einem Regler für eine grobe Verzögerungsregelung durch Kondensatoren und steuerbare Feldeffekttransistoren und für eine feine Verzögerungsregelung durch als steuerbare Feldeffekttransistoren ausgeführte Stromquellen.

Eine Phasenregelanordnung nach dem Oberbegriff von Anspruch 1 ist beispielsweise aus einem Artikel von M.G. Johnson, E.L. Hudson, "A Variable Delay Line PLL for CPU-Coprocessor Synchronization", IEEE Journal of Solid-State Circuits, Vol. 23, No. 5., October 1988, Seiten 1218-1223 bekannt und wird darin hinsichtlich einer Anwendung zur Synchronisierung zweier Prozessoren diskutiert. Beim Betrieb zweier Prozessoren, etwa eines Zentralprozessors und eines Coprozessors, an einem Bus treten nämlich häufig herstellungsbedingte Phasenverschiebungen der gleichfrequenten Signaltakte beider Prozessoren gegeneinander auf, die einen geregelten Buszugriff beider zumindest behindern. Zur Synchronisation beider Signaltakte werden Phasenregelkreise vorgeschlagen, die anstelle einer gesteuerten Oszillatorschaltung eine steuerbare Verzögerungseinrichtung aufweisen.

In dem genannten Artikel werden dazu zwei verschiedene Arten von Verzögerungseinrichtungen einander gegenübergestellt. Dies ist zum einen eine Schaltung mit einem Inverter, dessen Vesorgungsstrom mittels Feldeffekttransistoren in Abhängigkeit von einer Steuerspannung herabgesetzt wird, und zum anderen die eingangs bereits erwähnte Schaltung mit einem aus einem Kondensator und der Laststrecke eines Feldeffekttransistors gebildeten seriellen RC-Glieds, dessen Zeitkonstante mittels der Steuerspannung veränderbar ist. Die Inverterschaltung zeichnet sich durch einen großen Verzögerungsbereich aus - ist jedoch sehr ungenau. Diesbezüglich ist die Schaltung mit dem RC-Glied wesentlich günstiger. Dafür ist jedoch der Verzögerungsbereich sehr eingeschränkt. Um dennoch einen großen Verzögerungsbereich bei hoher Genauigkeit zu erzielen, wird vorgeschlagen, mehrere Schaltungen mit RC-Gliedern unter Zwischenschaltung von Invertern hintereinander zu schalten. Nachteilig ist jedoch, daß eine verhältnismäßig hohe Anzahl von einzelnen Schaltungen benötigt werden, um einen hinreichenden Verzögerungsbereich zu erzielen. Dies bedeutet aber, daß zahlreiche Kapazitäten benötigt werden, deren Flächenbedarf bei Integration sehr hoch ist.

Aufgabe der Erfindung ist es eine Phasenregelanordnung anzugeben, die diesen Nachteil nicht hat.

Die Aufgabe wird bei einer Phasenregelanordnung der eingangs genannten Art dadurch gelöst, daß in die Versorgungsleitungen des mindestens einen Inverters die Laststrecken zweier weiterer Feldeffekttransistoren geschaltet sind und daß die Laststrecken dieser Feldeffekttransistoren durch einen dem Phasendetektor nachgeschalteten, weiteren Regler zur Regelung in einem weiten Detektionsbereich gesteuert werden.

Eine Weiterbildung der Erfindung sieht vor, daß der weitere Regler einen Digital-Analog-Umsetzer zur Steuerung der weiteren Feldeffekttransistoren aufweist, dem ein durch ein Taktsignal getakteter Zähler vorgeschaltet ist, und daß die Zählrichtung des Zählers durch den Phasendetektor gesteuert wird. Weiterhin ist vorgesehen, bis zum Erreichen eines quasi stationären Regelzustandes des weiteren Reglers den einen Regler zu deaktivieren und nach Erreichen des quasi stationären Regelzustandes diesen zu halten und den einen Regler zu aktivieren.

Bei Ausgestaltungen der Erfindung werden schließlich die Zeitkonstante des einen Reglers geringer gewählt als die Zeitkonstante des weiteren Reglers und/oder der Phasendetektor aus zwei voneinander unabhängigen, jeweils durch das Referenzsignal und das Eingangssignal angesteuerte Teildetektoren aufgebaut, die jeweils einen der beiden Regler ansteuern.

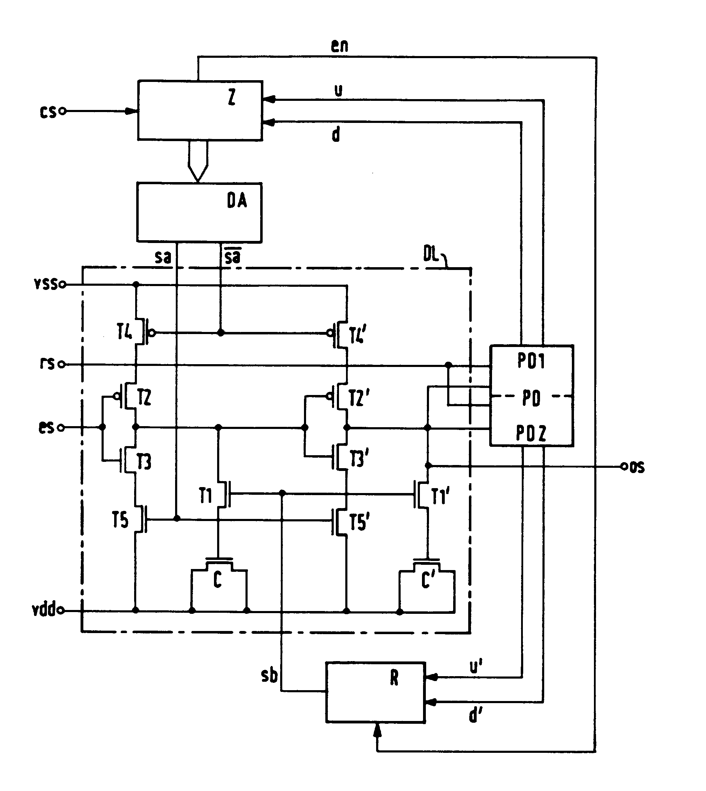

Die Erfindung wird nachfolgend anhand des in der einzigen Figur der Zeichnung dargestellten Ausführungsbeispiels näher erläutert.

Beim Ausführungsbeispiel sind als steuerbare Verzögerungseinrichtung DL zwei hintereinander geschaltete Inverter vorgesehen, die jeweils aus einem gate- und draingekoppelten Feldeffekttransistorpaar gegensätzlichen Leitungstyps bestehen. Demgemäß ist ein Eingangssignal es an die miteinander verbundenen Gateanschlüsse eines Feldeffekttransistors T2 vom p-Kanal-Typ und eines Feldeffekttransistors T3 vom n-Kanal-Typ angelegt. Die miteinander gekoppelten Drainanschlüsse dieser beiden Transistoren wiederum sind auf die miteinander gekoppelten Gateanschlüsse eines Feldeffekttransistors T2' vom p-Kanal-Typ und eines Feldeffekttransistors T3' vom n-Kanal-Typ geführt, deren miteinander verbundene Drainanschlüsse den Ausgang der Verzögerungseinrichtung DL bilden. In die Versorgungsleitungen der Inverter sind die Laststrecken von Feldeffekttransistoren T4, T4', T5, T5' geschaltet, die durch ein differenzielles Steuersignal sa, sa gesteuert werden. Dazu sind die Drainanschlüsse zweier sourceseitig an einem positiven Versorgungspotential vss angeschlossenen Feldeffekttransistoren T4, T4' vom p-Kanal-Typ jeweils mit den Sourceanschlüssen der Feldeffekttransistoren T2 und T2' verbunden. Entsprechend sind zwei sourceseitig an einem negativen Versorgungspotential vdd angeschlossene Feldeffekttransistoren T5 und T5' vom p-Kanal-Typ über ihre Drainanschlüsse jeweils mit den Sourceanschlüssen der Feldeffekttransistoren T3 und T3' verschaltet.

Den Ausgängen der Inverter sind jeweils Kondensatoren C und C' über die Laststrecke jeweils eines Feldeffekttransistors T1 bzw. T1' vom n-Kanal-Typ parallel geschaltet. Als Kondensatoren C und C' werden dabei ebenfalls Feldeffekttransistoren vom n-Kanal-Typ eingesetzt, bei denen Drain- und Sourceanschluß an das negative Versorgungspotential vdd gelegt sind und deren Gateanschluß jeweils mit dem Sourceanschluß des drainseitig mit dem Ausgang des jeweiligen Inverters verbundenen Feldeffekttransistors T1 bzw. T1' verschaltet ist. Die Gateanschlüsse der beiden Feldeffekttransistoren T1 und T1' werden dabei durch ein Steuersignal sb angesteuert. Die Steuersignale sa, sa und sb sind der Gestalt, daß sie die Temperaturdrift, der durch sie angesteuerten Feldeffekttransistoren ausgleicht. Das ist beispielsweise dann der Fall, wenn die jeweiligen Feldeffekttransistoren die Ausgangskreise jeweils eines Stromspiegels bilden, dessen Eingangskreis das jeweilige Steuersignal sa, sa und sb erzeugenden bildet.

Die differenziellen Steuersignale sa und sa werden durch einen Digital-Analog-Umsetzer DA in Abhängigkeit von dem Zählerstand eines Zählers Z erzeugt, der durch ein Taktsignal cs getaktet wird und dessen Zählrichtung durch ein Steuersignal ud umschaltbar ist. Der Digital-Analog-Umsetzer DA und der Zähler Z bilden dabei einen Regler. Das Steuersignal sb wird ebenfalls durch einen Regler, nämlich den Regler R, erzeugt, der beispielsweise aus einer umschaltbaren bipolaren Ladungspumpe mit nachgeschaltetem Filter besteht. Dabei ist in Ausgestaltung der Erfindung die Zeitkonstante des Reglers R geringer als die von dem Taktsignal cs abhängige Zeitkonstante des durch den Digital-Analog-Umsetzers DA und den Zähler Z gebildeten Reglers. Durch den Zähler Z wird zudem ein Steuersignal en erzeugt, mit dem Regler R aktiviert bzw. deaktiviert werden kann. Das Steuersignal en kann dabei nach Ablauf einer bestimmten Zeitspanne nach in Betriebnahme zur Aktivierung des Reglers R oder aber durch logische Verknüpfung der Signale u und e, erzeugt werden. Mit der Erzeugung des Steuersignals en wird der Zählerstand des Zählers Z festgehalten und der Regler R aktiviert.

Die Ansteuerung der beiden Regler erfolgt durch einen Phasendetektor PD, der in Ausgestaltung der Erfindung aus zwei voneinander unabhängigen Teildetektoren PD1 und PD2 besteht. Beide Teildetektoren PD1 und PD2 werden mit dem Ausgangssignal os der Verzögerungseinrichtung DL und mit einem Referenzsignal rs angesteuert. Der die Steuersignale u und d erzeugende Teildetektor PD1 weist dabei einen Detektionsbereich über mehrere Phasen bei geringer Genauigkeit auf, während der die Steuersignale u' und d' zur Ansteuerung des Reglers R erzeugende Teildetektor PD2 nur einen geringen Detektionsbereich aufweist bei einer relativ hohen Genauigkeit. Jedoch ist in gleicher Weise auch die Verwendung nur eines einzigen Phasendetektors möglich, der dann beide Regler steuert.

Schließlich ist darauf hinzuweisen, daß der gezeigte Regelkreis an beliebiger Stelle aufgetrennt werden kann und durch weitere Einheiten erganzt werden kann. Beispielsweise zur Synchronisation eines Zentralprozessors und eines Coprozessors wird ein Prozessortaktsignal über eine fest eingestellte Verzögerungseinrichtung dem Zentralprozessor zugeführt, der eine gegebene Gatterstrecke aufweist. Das Signal am Ausgang dieser Gatterstrecke dient im weiteren als Referenzsignal rs. Als Eingangssignal es ist das Prozessortaktsignal vorgesehen. Der Coprozessor wird nun mit dem Ausgangssignal os der steuerbaren verzögerungseinrichtung DL getaktet, wobei dieser eine zum Zentralprozessor identische Gatterstrecke aufweist. Die Gatterstrecke ist dabei zwischen die steuerbare Verzögerungseinrichtung DL und den Phasendetektor PD geschaltet. Somit werden die von den beiden Prozessoren an einen gemeinsamen Bus abgegebene Signaltakte aneinander angepaßt. Neben dieser Einsatzmöglichkeit eignet sich die erfindungsgemäße Phasenregelanordnung auch für alle weiteren, dem Fachmann geläufigen Anwendungen einer Phasenregelanordnung.

## Patentansprüche

1. Phasenregelanordnung mit einem Phasendetektor (PD), an den ein Referenzsignal (rs) sowie ein über eine steuerbare Verzögerungseinrichtung (DL) geführtes Eingangssignal (is) angelegt sind, mit einem dem Phasendetektor (PD) nachgeschalteten Regler (R), der die quer zwischen dem Signalpfad und jeweils einem Kondensator (C,C') geschaltete Laststrecke mindestens eines Feldeffekttransistors (T1, T1') in der Verzögerungseinrichtung (DL) zur Regelung in einem geringen Detektionsbereich steuert und mit mindestens einem Inverter (T2, T3, T2', T3') im Signalpfad der Verzögerungseinrichtung (DL),
**dadurch gekennzeichnet**, daß in die Versorgungsleitungen des mindestens einen Inverters (T2, T3, T2', T3') jeweils die Laststrecken zweier weiterer Feldeffekttransistoren (T4, T5, T4', T5') geschaltet sind und daß die Laststrecken der weiteren Feldeffekttransistoren (T4, T5, T4', T5') durch einen dem Phasendetektor (PD) nachgeschalteten, weiteren Regler (DA, Z) zur Regelung in einem weiten Detektionsbereich gesteuert werden.

2. Phasenregelanordnung nach Anspruch 1,
**dadurch gekennzeichnet**, daß der weitere Regler einen Digital-Analog-Umsetzer (DA) zur Steuerung der weiteren Feldeffekttransistoren (T4, T5, T4', T5') aufweist, dem ein durch ein Taktsignal (cs) getakteter Zähler (Z) vorgeschaltet ist und daß die Zählrichtung des Zählers (Z) durch den Phasendetektor (PD) gesteuert wird.

3. Phasenregelanordnung nach Anspruch 1 oder 2,
**dadurch gekennzeichnet**, daß bis zum Erreichen eines quasistationären Regelzustandes des weiteren Reglers (DA, Z) der eine Regler (R) deaktiviert ist und daß nach Erreichen des quasistationären Regelzustandes dieser gehalten und der eine Regler (R) aktiviert wird.

4. Phasenregelanordnung nach einem der Ansprüche 1 bis 3,
**dadurch gekennzeichnet**, daß die Zeitkonstante des einen Reglers (R) geringer ist als die Zeitkonstante des weiteren Reglers (DA, Z).

5. Phasenregelanordnung nach einem der Ansprüche 1 bis 4,
**dadurch gekennzeichnet**, daß der Phasendetektor (PD) aus zwei voneinander unabhängigen, jeweils durch das Referenzsignal (rs) und das Eingangssignal (es) angesteuerten Teildetektoren (PD1, PD2) besteht, die jeweils einen der beiden Regler (R, DA, Z) ansteuern.

## Claims

1. Phase regulating arrangement having a phase detector (PD), to which a reference signal (rs) and an input signal (is) are applied, the said input signal being passed via a controllable delay device (DL), having a regulator (R), which is connected downstream of the phase detector (PD) and controls the load path, shunt-connected between the signal path and a respective capacitor (C, C'), of at least one field-effect transistor (T1, T1') in the delay device (DL) for the purpose of regulation in a small detection range, and having at least one inverter (T2, T3, T2', T3') in the signal path of the delay device (DL),
characterized in that the respective load paths of two further field-effect transistors (T4, T5, T4', T5') are connected into the supply lines of the at least one inverter (T2, T3, T2', T3'), and in that the load pat-hs of the further field-effect transistors (T4, T5, T4', T5') are controlled by a further regulator (DA, Z) for the purpose of regulation in a wide detection range, the said further regulator being connected downstream of the phase detector (PD).

2. Phase regulating arrangement according to Claim 1,
characterized in that the further regulator has a digital-to-analog converter (DA) for controlling the further field-effect transistors (T4, T5, T4', T5'), a counter (Z) clocked by a clock signal (cs) being connected upstream of the said converter, and in that the counting direction of the counter (Z) is controlled by the phase detector (PD).

3. Phase regulating arrangement according to Claim 1 or 2,
characterized in that until a quasi-steady regulating state of the further regulator (DA, Z) is reached, the first regulator (R) is deactivated, and in that after the quasi-steady regulating state is reached, the said further regulator is stopped and the first regulator (R) is activated.

4. Phase regulating arrangement according to one of Claims 1 to 3,
characterized in that the time constant of the first regulator (R) is lower than the time constant of the further regulator (DA, Z).

5. Phase regulating arrangement according to one of Claims 1 to 4,
characterized in that the phase detector (PD) comprises two mutually independent detector elements (PD1, PD2), which are each driven by the reference signal (rs) and the input signal (es) and each drive one of the two regulators (R, DA, Z).

## Revendications

1. Dispositif de réglage de phase comportant un détecteur (PD) de phase, auquel sont appliqués un signal (rs) de référence ainsi qu'un signal (is) d'entrée envoyé par l'intermédiaire d'un dispositif (DL) à retard pouvant être commandé, un régulateur (R) qui est monté en aval du détecteur (PD) de phase et qui commande, pour le réglage dans un petit domaine de détection, la section de charge, d'au moins un transistor (T1, T1') à effet de champ du dispositif (DL) à retard branchée transversalement entre la voie de signal et un condensateur (C, C') respectif, et au moins un inverseur (T2,T3,T2',T3') dans la voie de signal du dispositif (DL) à retard,
caractérisé en ce qu'il est monté dans les conducteurs d'alimentation dudit au moins un inverseur (T2,T3,T2',T3'), les sections de charge de deux transistors à effet de champ (T4,T5,T4',T5') supplémentaires et en ce que les sections de charge des transistors à effet de champ (T4,T5,T4',T5') supplémentaires sont commandés, pour le réglage dans un domaine de détection large, par un régulateur (DA, Z) supplémentaire branché en aval du détecteur (PD) de phase.

2. Dispositif de réglage de phase suivant la revendication 1, caractérisé en ce que le régulateur supplémentaire comporte, pour- la commande des transistors (T4,T5,T4',T5') à effet de champ supplémentaire, un convertisseur (DA) numérique analogique, en amont duquel est branché un compteur (Z) cadencé par un signal (cs) de cadencement et en ce que le sens de comptage du compteur (Z) est commandé par le détecteur (PD) de phase.

3. Dispositif de réglage de phase suivant la revendication 1 ou 2, caractérisé en ce que jusqu'à l'obtention d'un état de réglage quasi stationnaire du régulateur (DA, Z) supplémentaire, ledit un régulateur (R) est désactivé et en ce que, après l'obtention de l'état de réglage quasi stationnaire, cet état est maintenu et ledit un régulateur (R) est activé.

4. Dispositif de réglage de phase suivant l'une des revendications 1 à 3, caractérisé en ce que la constante dudit un régulateur (R) est plus petite que la constante de temps du régulateur (DA, Z) supplémentaire.

5. Dispositif de réglage de phase suivant l'une des revendications 1 à 4, caractérisé en ce que le détecteur (PD) de phase est constitué de deux détecteurs (PD1, PD2) partiels indépendants l'un de l'autre, auxquels sont appliqués respectivement le signal (rs) de référence et de signal (es) d'entrée, chacun des détecteurs partiels commandant l'un des deux régulateurs (R, DA, Z).
